# EUROPEAN PATENT SPECIFICATION

(11) **EP 3 355 666 B1**
(45) Date of publication and mention of the grant of the patent: **26.07.2023**
(21) Application number: 17153335.9
(22) Date of filing: 26.01.2017
(51) Int. Cl.: H05K 1/18, H01L 23/538

(54) **SEMIFINISHED PRODUCT AND METHOD OF MANUFACTURING A COMPONENT CARRIER**
HALBFABRIKAT UND VERFAHREN ZUR HERSTELLUNG EINES KOMPONENTENTRÄGERS
PRODUIT SEMI-FINI ET PROCÉDÉ DE FABRICATION D'UN SUPPORT DE COMPOSANT

(43) Date of publication of application: 01.08.2018
(73) Proprietor: AT & S Austria Technologie & Systemtechnik Aktiengesellschaft, 8700 Leoben (AT)
(72) Inventor: Gavagnin, Marco, 8700 Leoben (AT); Krivec, Thomas, 8740 Zeltweg (AT)
(74) Representative: Donatello, Daniele

(56) References cited:
- JP-B2- 5 569 676
- US-A1- 2005 233 122
- US-A1- 2005 285 244
- US-A1- 2006 142 406
- US-A1- 2008 142 951
- US-A1- 2009 218 118
- US-A1- 2012 206 890

## Description

The invention relates to a semifinished product and a method of manufacturing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, mounting devices shall be mechanically robust so as to be operable even under harsh conditions.

In view of these boundary conditions, embedding of a component in a component carrier is challenging.

Document US 2005/285244 A1 discloses a method of manufacturing a component carrier where a component is provided in a recess of a layer onto a temporary carrier, and is subsequently attached to the layer through liquid material provided in the gap between the component and the layer.

Document US 2009/218118 A1 discloses an alternative method in which the the gap between the component and the recess is filled with a solid material.

It is an object of the invention to provide an architecture for component carriers which allows embedding electronic components in a simple way while ensuring high mechanical integrity.

In order to achieve the object defined above, a semifinished product and a method of manufacturing a component carrier according to the independent claims are provided.

An auxiliary structure for embedding (or integrating) a component in a component carrier is provided, wherein the auxiliary structure comprises a solid state transition piece (in particular being solid under standard temperature and pressure) for at least partially, in particular substantially fully circumferentially, enclosing the component, wherein the solid-state transition piece comprises or consists of a material being or becoming adhesive in a liquid state and being liquefiable by heat and/or pressure so as to fill (in particular in an adhesive manner) a gap between the component and surrounding component carrier material by applying heat and/or pressure.

According to the invention, a semifinished product obtainable during manufacturing a component carrier according to claim 1 is provided, wherein the semifinished product comprises component carrier material with a recess, and an auxiliary structure having the above mentioned features, wherein the solid-state transition piece is located within the recess so as to define at least part of an accommodation volume for arranging a component therein.

According to the invention, a method of manufacturing a component carrier in accordance to claim 12 is provided, wherein the method comprises arranging a component in a recess of a component carrier material, at least partially, in particular substantially fully circumferentially, surrounding the component by a solid state transition piece (which may comprise or consist of a material being adhesive in at least one phase state, in particular in the liquid phase state), and transferring (in particular by applying heat and/or pressure) the transition piece into an adhesive state (in particular by temporarily liquefying the transition piece) so as to (in particular fully or partially) adhesively fill a gap between the component and the surrounding component carrier material.

According to a preferred embodiment of the invention, a semifinished product having the above mentioned features is used for embedding a component in a component carrier.

In the context of the present application, the term "substantially fully circumferentially enclosing" may particularly denote that at least a major portion of the circumference of the component is contacted by or arranged directly next to a respective portion of the auxiliary structure. For example, at least 90% of the circumference of the component may be enclosed by material of the auxiliary structure. This can be accomplished for example by an integrally formed frame-shaped transition piece of the auxiliary structure, by a transition piece composed of multiple individual bodies put together to form a surrounding, or by a for instance granulate-type material arranged around the component as auxiliary structure. Hence, the presence of one or more small gaps around the perimeter of the component in which no material of the auxiliary structure is present, shall not be excluded by the term "substantially fully circumferentially enclosing". However, it is in particular possible that the transition piece fully circumferentially encloses the component or is adapted therefore.

In the context of the present application, the term "component carrier" may particularly denote any support structure which is capable of accommodating one or more electronic components thereon and/or therein for providing both mechanical support and electrical connectivity.

In the context of the present application, the term "semifinished product" may particularly denote a physical structure which is not yet readily manufactured but requires further processing to obtain a final product which can functionally serve as stand-alone component carrier. In other words, a semifinished product may be a pre-form of a component carrier to be manufactured based on the semifinished product.

In the context of the present application, the term "electronic component" may particularly denote any bulky rather than layer-type active (such as a semiconductor chip or semiconductor package) or passive (for instance a copper block) component embedded within an interior of the component carrier.

According to the invention, an auxiliary structure with a transition piece of initially solid material is arranged between component carrier material and a component to be embedded within the component carrier material. The transition piece material (which may be non-adhesive in the solid state) may be transferred into another state (in particular a liquid state) in which it is adhesive and preferably flowable. Interposing the auxiliary transition piece structure in a correspondingly shaped recess between component carrier material and component - while the material of the transition piece is still solid and preferably non-adhesive - allows a simple handling of the auxiliary structure. Subsequently, by initiating a phase change of the transition piece (for instance by merely liquefying the transition piece), an integral adhesive connection between the component carrier material and the embedded electronic component is established via the now adhesive transition piece material. Thereafter, the transition piece material may be re-solidified. Thereby, embedding of or integrating a component of substantially any desired material in component carrier material of substantially any desired material is made possible with low effort. Since the material of the transition piece can be substantially freely selected, a board designer is furthermore provided with the opportunity to adjust the material of the transition piece for accomplishing one or more further technical functions of the manufactured component carrier (such as adjustment of thermal conductivity, suppression of thermal mismatch and/or warpage, reduction of mechanical tension at an interface between electronic component and the component carrier material, etc.).

In the following, further exemplary embodiments of the auxiliary structure, the semifinished product, and the methods will be explained.

In an embodiment, the transition piece is a single integral body. This allows a simple handling of the transition piece (for instance by a pick and place apparatus) and ensures an adhesive connection around the entire circumference of the component.

In an embodiment, the transition piece comprises a plurality of separate transition piece constituents (such as strips) arrangable for at least partially, in particular substantially fully circumferentially, enclosing a component. This allows to partially or entirely surround electronic components with even complex shape in a flexible way.

In an embodiment, the solid-state transition piece comprises a curable or at least partially uncured material, in particular a cross-linkable material (such as a resin which may experience cross-linking at elevated temperature and/or pressure). In the context of the present application, the term "at least partially uncured material" particularly denotes material which has the property to at least partially melt or become flowable by the application of elevated pressure and/or elevated temperature, and become fully hardened or cured (and thereby becomes solid) when releasing the applied elevated pressure and/or elevated temperature. Consequently, applying elevated pressure and/or elevated temperature may cause melting of the curable or at least partially uncured material, followed by an irreversible hardening upon releasing the applied high pressure and/or high temperature. In particular, the "at least partially uncured material" may comprise or consist of B-stage material and/or A-stage material. By providing a transition piece from prepreg or any other B-stage material, the transition piece may re-melt during lamination so that resin (or the like) may flow for interconnecting the various elements and for closing gaps or voids and may therefore contribute to a stable intrinsic interconnection within the component carrier under manufacture.

In particular, triggering the curing may also trigger the transition of the transition piece material into the adhesive and flowable state (for instance a liquid phase), which may in turn initiate the adhering procedure.

In an embodiment, the solid-state transition piece comprises:
- at least partially uncured resin, in particular B-stage resin, more particularly B-stage prepreg (this material selection may be advantageous, since this material is very similar to typical component carrier material which has a positive impact on thermal mismatch and related effects); and/or
- a thermoplastic material; and/or
- a hot melt adhesive; and/or
- a precursor of an adhesive foam (this material may be particularly advantageous, since a foam has the advantage of being properly compressible, so that the foam material may not only adhere the component and the component carrier material together, but may also balance out or reduce mechanical tension in an interior of the component carrier).

In an embodiment, the transition piece has a polygonal perimeter, in particular a rectangular perimeter, more particularly a square perimeter. Preferably, the transition piece is a (for instance closed) annular ring structure so as to provide an adhesive function around the entire perimeter of a component.

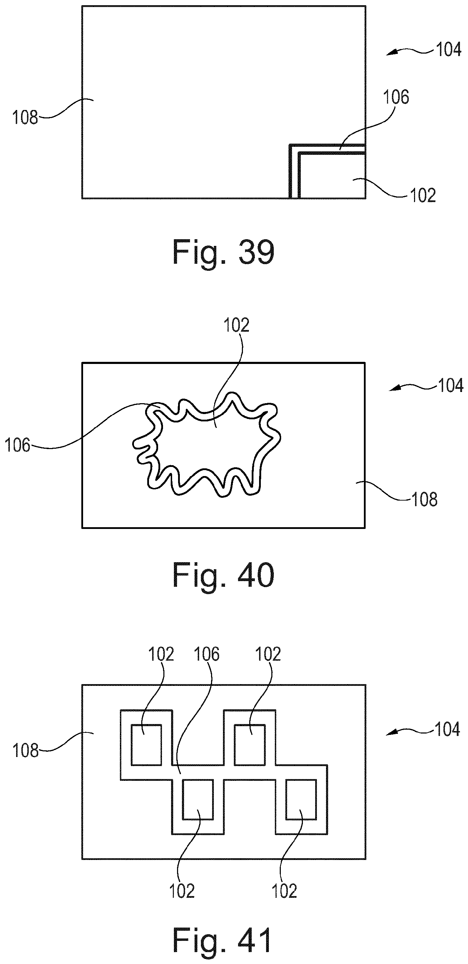

Alternatively, the transition piece may be provided with an irregular perimeter (compare for example Figure 40). When the transition piece is provided with such a free-form (for instance has a wave form) its surface may be increased, thereby enabling the transition piece to provide a better mechanical stability to the component and the component carrier material.

In an embodiment, the auxiliary structure further comprises the component integrally formed with the surrounding transition piece. This allows to reduce the number of pieces to be handled during manufacture.

In an alternative embodiment, the auxiliary structure further comprises component carrier material integrally formed with and surrounding the transition piece. This also allows to reduce the number of pieces to be handled during manufacture.

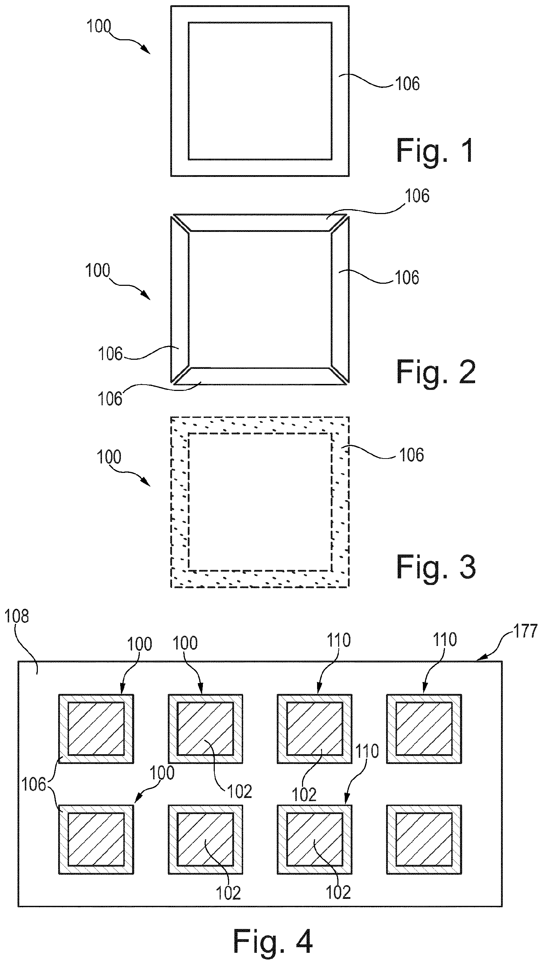

In an embodiment, the transition piece is a circumferentially closed frame (compare for instance Figure 1). Thus, the transition piece may be configured as an annular structure surrounding the entire component. Such a frame simplifies handling and ensures a uniform connection between component and component carrier material along an entire perimeter of the component.

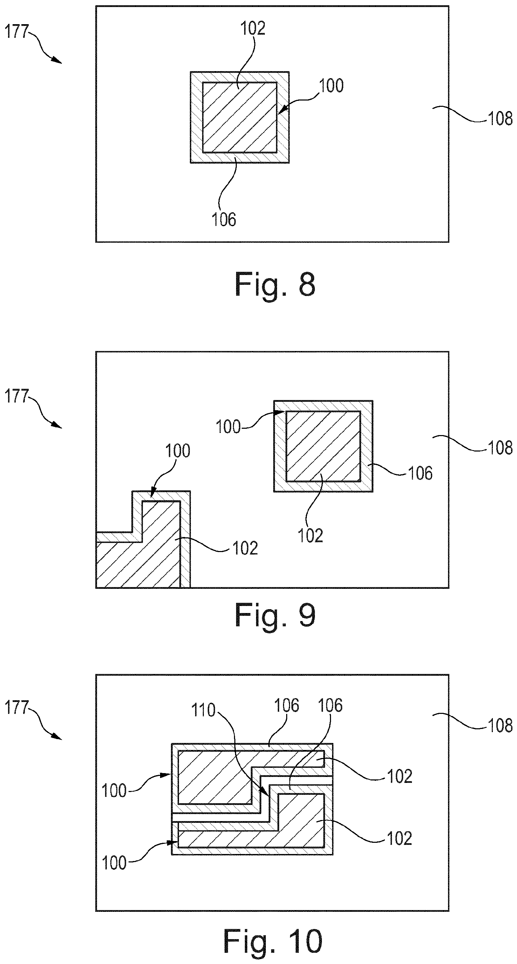

In another embodiment, the transition piece is an open structure which has (in particular two) free ends (compare for example Figure 39). This may be in particular advantageous when a part of the component shall form part of an exterior surface of the readily manufactured component carrier, but is not considered to be part of the invention. For instance, such a transition piece may be L-shaped, T-shaped, U-shaped, or may have an even more complex structure (compare for example Figure 9).

In an embodiment, the transition piece is formed by:
- a single annular structure (which simplifies handling); or
- a plurality of separate strips (which provides a high flexibility in terms of transition piece shape); or
- a granulate (which provides the opportunity to fill even small gaps between component carrier material and electronic component or gaps of differing width).

In an embodiment, the semifinished product further comprises a further auxiliary structure having a further solid-state transition piece located within the component carrier material so as to define a further accommodation volume for arranging a further electronic component therein. Thus, multiple auxiliary structures in combination with one component carrier material body allows the embedding of multiple electronic components, preferably in a simultaneous embedding procedure.

In an embodiment, the auxiliary structure and the further auxiliary structure are located in separate recesses in the component carrier material. Separate non-consecutive sections of a component carrier may therefore be equipped with electronic components providing different electronic functionalities in the various sections.

In an embodiment, the auxiliary structure and the further auxiliary structure are located in a common recess in the component carrier material to thereby delimit different accommodation volumes for different electronic components. This keeps the effort of embedding multiple electronic components small, since only a single recess is sufficient for accommodating more than one electronic component. Such an embodiment is also in particular advantageous when multiple electronic components functionally cooperate to provide a common electronic function, because the signal path between the components may then be kept very short.

In an embodiment, the auxiliary structure and the further auxiliary structure together substantially fully circumferentially surround the common recess, and at least one of the auxiliary structure and the further auxiliary structure divides the recess into the different accommodation volumes. By taking this measure, the transition piece structure(s) not only contribute(s) to an adhesion of a component to be embedded with regard to surrounding material, but also define(s) different accommodation volumes for different electronic components and thereby prevent(s) an erroneous placement of a component.

In an embodiment, the component carrier material comprises a core, in particular comprising fully cured dielectric material. In the context of the present application, the term "core" may particularly denote already cured electrically insulating material providing a stable base for embedding one or more electronic components. A core may be made of cured resin (such as epoxy resin) with fibers (such as glass fibers) embedded therein, for example FR4. In particular, such a core may be made of a thickness being higher than that of a single layer (such as a prepreg layer) as used in PCB technology. In the context of the present application, the term "fully cured" may particularly denote a material property according to which the corresponding material (such as resin) is not capable any more of being re-melted to become flowable and of being subsequently re-solidified for interconnecting various elements of the manufactured component carrier. In particular, resin material of the fully cured core may be already cross-linked. Thus, the fully cured core material may be C-stage material rather than A-stage or B-stage material.

In an embodiment, at least part of at least one main surface of the component carrier material, the component and material of the transition piece is covered with at least one electrically insulating layer structure and/or at least one electrically conductive layer structure. In particular, it is possible to laminate at least one electrically conductive layer structure and/or at least one electrically insulating layer structure on the component and the component carrier material. In the context of the present application, the term "layer structure" may particularly denote a full or continuous layer, a patterned layer, or a plurality of islands-type separate elements formed together within a plane. Thus, any multilayer component carrier may be manufactured, in particular by lamination, based on a semifinished product according to an exemplary embodiment of the invention. It is particularly preferred to carry out the lamination of the mentioned layer structures and the phase transition of the transition piece material by a common simultaneous procedure.

In an embodiment, a material of the solid state transition piece is selected so as to reduce mechanical load in a transition region between the component carrier material and the component. For instance, this can be accomplished by a soft and/or compressible material of the transition piece.

In an embodiment, a material of the solid state transition piece is selected so as to reduce a thermal expansion mismatch between the component carrier material and material of the component. For example, a material of the solid-state transition piece may have a value of the coefficient of thermal expansion (CTE value) in between a CTE value of the component carrier material and a CTE value of the component. Thereby, a smoother transition in terms of thermal expansion properties can be established.

In an embodiment, a material of the solid state transition piece is selected to provide a thermal conductivity higher than the thermal conductivity of the component carrier material and/or the component. By taking this measure, the heat removal capability of the manufactured component carrier can be improved by the material of the transition piece.

In an embodiment, a material of the solid state transition piece is selected to provide a high frequency compatibility better than a high frequency compatibility of the component carrier material and/or the material of the component. Therefore, the range of electronic applications for which the component carrier can be employed can be extended to high frequency applications.

In an embodiment, the auxiliary structure is manufactured by molding. This allows a cost efficient manufacture of transition pieces on a large scale. Alternatively, the auxiliary structure may be manufactured by punching (in particular from a band, tape or ribbon) or thermoforming (in particular deep drawing).

In an embodiment, the method comprises arranging at least one further electronic component in the recess, and at least partially (in particular substantially fully circumferentially) surrounding the plurality of electronic components by one and the same solid state transition piece. Thus, one transition piece may efficiently (partially or entirely) surround and adhere multiple electronic components at the same time.

In an embodiment, the method comprises arranging at least one further electronic component in at least one further recess of the component carrier material, at least partially (in particular substantially fully circumferentially) surrounding the at least one further electronic component by at least one further solid state transition piece which comprises or consists of an adhesive material, and temporarily liquefying the at least one further transition piece by heat and/or pressure so as to fill a gap between the at least one further electronic component and the surrounding component carrier material. Thus, the curing of multiple transition pieces may be performed on a panel level or in a batch procedure at the same time. This allows to manufacture component carriers with a high throughput.

In an embodiment, the method further comprises singularizing an obtained structure into a plurality of separate component carriers, each comprising a portion of the component carrier material, and at least one of the components partially or entirely surrounded by material of at least one of the transition pieces. After a common manufacturing of multiple component carriers on a batch level, separation may be accomplished, for example by sawing, laser cutting, or etching.

In an embodiment, the component carrier comprises a stack of at least one electrically insulating layer structure and at least one electrically conductive layer structure. For example, the component carrier may comprise a laminate of the mentioned electrically insulating layer structure(s) and electrically conductive layer structure(s), in particular formed by applying mechanical pressure, if desired supported by thermal energy. The mentioned stack may provide a plate-shaped component carrier capable of providing a large mounting surface for further electronic components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, and a substrate (in particular an IC substrate).

In the context of the present application, the term "printed circuit board" (PCB) may particularly denote a component carrier (which may be plate-shaped (i.e. planar), three-dimensionally curved (for instance when manufactured using 3D printing) or which may have any other shape) which is formed by laminating several electrically conductive layer structures with several electrically insulating layer structures, for instance by applying pressure, if desired accompanied by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming through-holes through the laminate, for instance by laser drilling or mechanical drilling, and by filling them with electrically conductive material (in particular copper), thereby forming vias as through-hole connections. Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier having substantially the same size as a component (in particular an electronic component) to be mounted thereon. More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing spheres (such as glass spheres).

In an embodiment, the at least one electrically insulating layer structure comprises at least one of the group consisting of resin (such as reinforced or non-reinforced resins, for instance epoxy resin or Bismaleimide-Triazine resin, more specifically FR-4 or FR-5), cyanate ester, polyphenylene derivate, glass (in particular glass fibers, multi-layer glass, glass-like materials), prepreg material, polyimide, polyamide, liquid crystal polymer (LCP), epoxy-based Build-Up Film, polytetrafluoroethylene (Teflon), a ceramic, and a metal oxide. Reinforcing materials such as webs, fibers or spheres, for example made of glass (multilayer glass) may be used as well. Although prepreg or FR4 are usually preferred, other materials may be used as well. For high frequency applications, high-frequency materials such as polytetrafluoroethylene, liquid crystal polymer and/or cyanate ester resins may be implemented in the component carrier as electrically insulating layer structure.

In an embodiment, the at least one electrically conductive layer structure comprises at least one of the group consisting of copper, aluminum, nickel, silver, gold, palladium, and tungsten. Although copper is usually preferred, other materials or coated versions thereof are possible as well, in particular coated with supra-conductive material such as graphene.

The at least one component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. For example, the component can be an active electronic component, a passive electronic component, an electronic chip, a storage device (for instance a DRAM or another data memory), a filter, an integrated circuit, a signal processing component, a power management component, an optoelectronic interface element, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element or a ferrimagnetic element, for instance a ferrite core) or may be a paramagnetic element. However, the component may also be a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In another embodiment, the at least one component may be a further component carrier (such as a further printed circuit board or an IC substrate). Thereby, the described transition piece architecture also allows to establish board-in-board configurations.

In an embodiment, the component carrier is a laminate-type component carrier. In such an embodiment, the component carrier is a compound of multiple layer structures which are stacked and connected together by applying a pressing force, if desired accompanied by heat.

The aspects defined above and further aspects of the invention are apparent from the examples of embodiment to be described hereinafter and are explained with reference to these examples of embodiment.
Figure 1 to Figure 3 illustrate plan views of auxiliary structures for embedding a component in a component carrier.
Figure 4 illustrates a plan view of a semifinished product of a batch procedure of manufacturing a plurality of component carriers according to an exemplary embodiment of the invention.
Figure 5 to Figure 7 illustrate plan views of a procedure of embedding electronic components in a recess of component carrier material using an auxiliary structure according to exemplary embodiments of the invention.
Figure 8 to Figure 10 illustrate plan view of semifinished products according to exemplary embodiments of the invention.
Figure 11 to Figure 16 illustrate cross-sectional views of component carriers manufactured by methods of manufacturing component carriers according to exemplary embodiments of the invention.
Figure 17 to Figure 21 illustrate cross-sectional views of structures obtained during carrying out methods of manufacturing component carriers according to exemplary embodiments of the invention.
Figure 22 to Figure 25 illustrate further cross-sectional views of further structures obtained during carrying out the method described referring to Figure 17 to Figure 21.
Figure 26 to Figure 29 illustrate alternative further cross-sectional views of further structures obtained during carrying out the method described referring to Figure 17 to Figure 21.
Figure 30 to Figure 34 illustrate cross-sectional views of structures obtained during carrying out methods of manufacturing component carriers according to other exemplary embodiments of the invention.
Figure 35 to Figure 37 illustrate further cross-sectional views of further structures obtained during carrying out the method described referring to Figure 30 to Figure 34.
Figure 38 shows a three-dimensional view of a semifinished product on batch level obtained during manufacturing component carriers according to an exemplary embodiment of the invention.
Figure 39 shows a plan view of a component carrier in which a transition piece unifies component carrier material and a component to be connected thereto according to an illustrative example not forming part of the invention.
Figure 40 shows a plan view of a component carrier in which a freely shaped transition piece is arranged between surrounding component carrier material and a component to be recessed or embedded in the component carrier material according to another exemplary embodiment of the invention.
Figure 41 shows a plan view of a component carrier in which a transition piece is arranged between component carrier material and multiple components to be recessed or embedded in the component carrier material according to another exemplary embodiment of the invention.

The illustrations in the drawings are schematical. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment, an architecture for embedding a component in a component board using one or more transition pieces is provided which is or are preferably shaped as a frame. In particular, such a concept allows component integration in a printed circuit board (PCB) or any other component carrier using tailored transition pieces.

Embedding (or integrating) a component in a printed circuit board may lead to several advantages, such as device miniaturization, signal performance, heat management, hardware security, etc. However, the embedding (or integration) process is challenging. Many challenges have to be overcome, for instance warpage issues and issues related to material mismatch between component and printed circuit board (PCB) base substrates. In order to overcome such challenges, it may be beneficial to introduce an appropriate material positioned between the component to be integrated and the surrounding component carrier material. Exemplary embodiments of the invention provide geometry and physical properties of transition piece structures being appropriate for framing an integrated component into the component carrier material.

An advantageous embodiment of the invention is the placement of a transition piece surrounding a component which is going to be integrated within component carrier material. The transition piece can be pre-cut from many different kinds of materials. Appropriate materials for the transition piece can be composed of the same material as the main board (i.e. materials being identical or similar to materials of the component carrier material, such as prepreg) or even a different one. Particularly, this latter mentioned option may be beneficial, since it enables a proper mismatch reduction concerning the different physical properties of the component to be embedded and the component carrier material (such as a main PCB). One or more of the properties which may be compensated between the embedded electronic component and the component carrier material are coefficient of thermal expansion (CTE) and elastic module (or stiffness), etc. Additionally, depending on the component to be integrated, the transition piece material can be characterized also by low dielectric constant and/or low losses, supporting high frequency devices. The transition piece material can be advantageously in a pre-cured status, allowing the proper gap-filling between integrated component and component carrier material/main PCB during a lamination process.

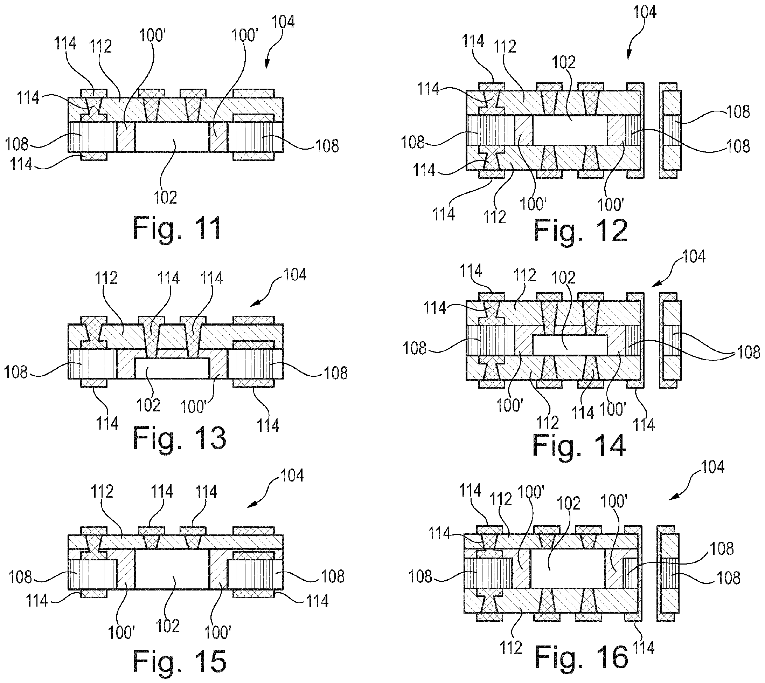

Exemplary products resulting from such an integration strategy are represented in Figure 11 to Figure 16 described below in further detail. It has to be mentioned that, while in Figure 12 and Figure 14 and Figure 16 the components are contacted either on both sides, they can also be contacted only on one surface. Furthermore, a sequential buildup of the products shown in Figure 11 to Figure 16 can be executed in order to add further layers of dielectric and structured copper layers, or proceeding with multiple core build ups.

One advantageous measure which can be taken according to exemplary embodiments is the positioning of a pre-cut transition piece within a hole and a component within such a transition piece.

Processes which can be carried out according to exemplary embodiments of the invention can be divided in particular into the following two categories:
(i) integration of a component into a dielectric material cladded (for instance copper clad laminate) in both sides by a copper foil, or
(ii) uncladded dielectric material.

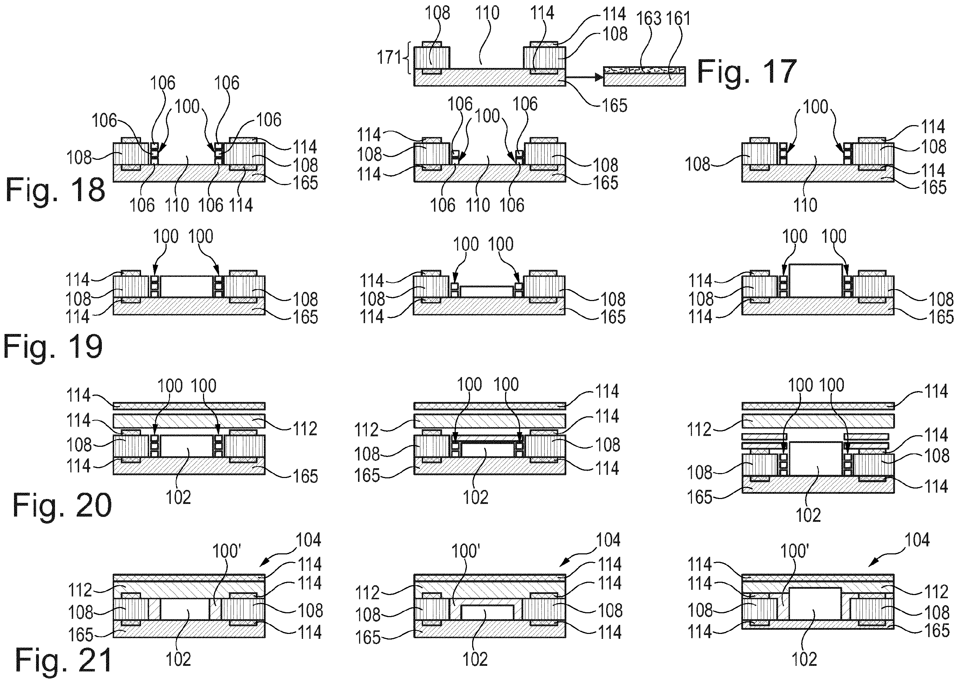

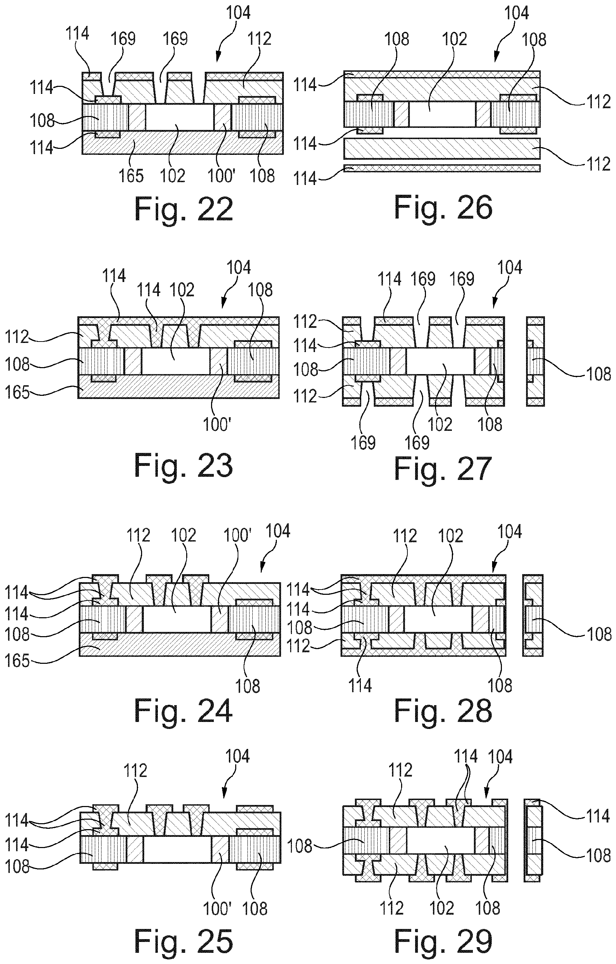

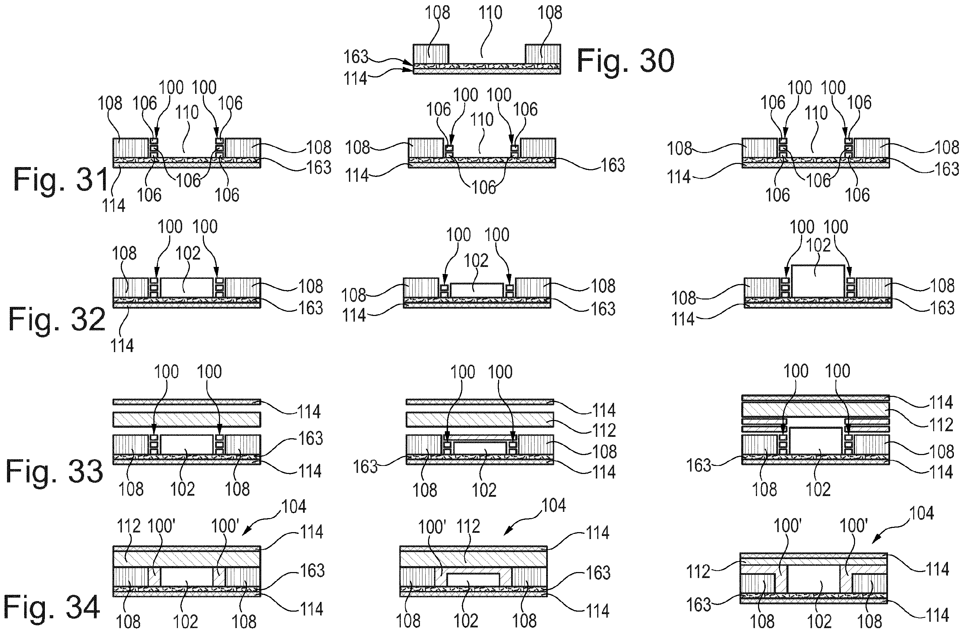

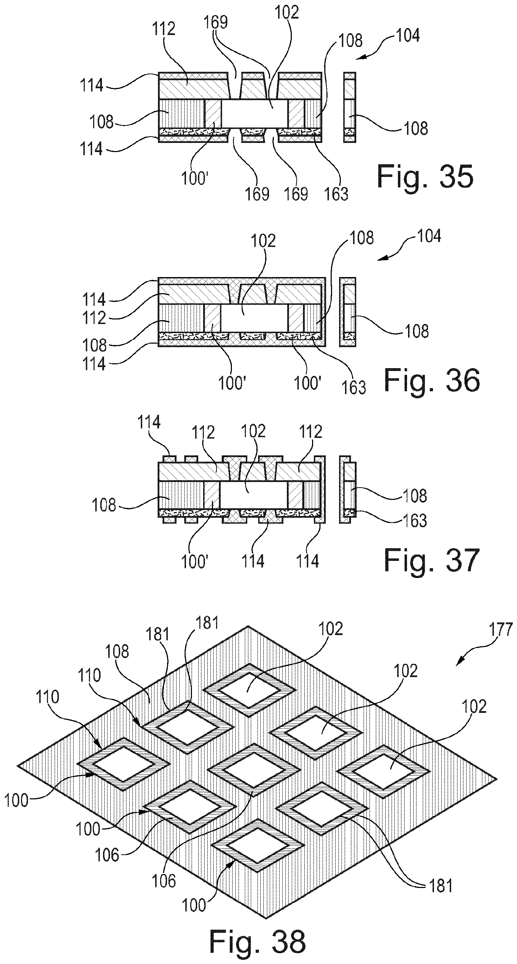

In particular, the dielectric material can be glass reinforced and either cured or partially cured. An exemplary procedure according to (i) is represented in Figure 17 to Figure 21. For simplicity, a possible process continuation has been represented uniquely for a component as thick as the core (see Figure 22 to Figure 25, and Figure 26 to Figure 29), but it is the same for all three described possibilities. On the other hand, Figure 30 to Figure 34 show procedures which may be taken in process (ii). Also in this case, for the sake of simplicity, the process continuation has been represented uniquely for a component as thick as the core (see Figure 35 to Figure 37), but it is the same for all three described possibilities.

The transition piece geometry of exemplary embodiments of the invention is not limited, and it can be chosen according to the geometry of the component to be inserted. Moreover, the processes hereby described are scalable and can be used on panel level (compare for example Figure 38).

However, an advantageous embodiment of the invention is based on the use of a pre-cut transition piece in order to embed a component in a component carrier such as a printed circuit board (PCB). Such a transition piece may be made of another (in particular dielectric) material than that (in particular dielectric) material characterizing the component carrier material.

Just as examples, the component to be enclosed can be:
- a passive component (for instance a resistor, a capacitor, etc.)
- an active component (for instance an integrated circuit, a microchip, etc.)
- in a board-in-board configuration, another component carrier (for instance another PCB) with different complexity, or properties (for example high frequency compatibility), compared to the surrounding one
- a battery (for example a solid state lithium ion battery)
- a magnetic core (for example a ferrite block)

The embedding architecture of an exemplary embodiment of the invention relies on the use of materials in form of transition pieces, capable of mitigating stress by introducing for example plastic deformation or by being able to compensate volumetric shrinkage. These materials may exhibit one or more of tailored CTE, glass temperature, Young modulus, etc., depending on their final use. Warpage may also be reduced by using a fully cured dielectric with pre-cut holes giving the stability, while the material surrounding the component may be an uncured dielectric, which homogeneously fills the gap between electronic component and cured dielectric component carrier material.

Stress mitigation may be obtained by the ability of the material to compensate temperature induced mechanical deformation of prepreg as well as of an embedded electronic component (such as a semiconductor die). Materials that can be applied provide a relatively high compressibility, i.e. materials capable to perform volumetric changes without generating high stress, and also relatively high plasticity. The range of the Young modulus may be advantageously relatively low, for instance lower than 1000 MPa.

Materials appropriate for the transition piece according to exemplary embodiments are chemically crosslinked materials (such as loosely linked thermosets, elastomers) as well as thermoplastic materials, for instance with homogenous bulk, multi-phase (material featuring a second plasticity phase, similar to the butadiene fraction in High Impact Polystyrene), or foam structured.

Furthermore, in case the embedded inner state electronic component requires the use of high frequency, it is possible to choose a proper transition piece characterized by very low dielectric constant and low losses. In this way, such high performance material may be only locally integrated instead of being used over the whole board or component carrier.

Another advantage of exemplary embodiments of the invention is that, for large components, a proper material can be pre-cut in a transition piece and positioned in the gap between component carrier material and electronic component, thereby reducing the time required to fill such a gap by dispensing, ink-jetting, screen printing, etc.

Handling of the transition piece can be accomplished according to an exemplary embodiment of the invention by a pick-and-place machine. Another possibility is to position the pre-cut transition pieces on a vacuum plate, align such a vacuum plate over the component carrier material with pre-cut holes and interrupt the vacuum, letting fall by gravity the transition pieces into the holes. In this way all gaps may be filled by the transition pieces simultaneously. Such a procedure is compatible with a batch manufacturing process.

In another embodiment, it is possible to firstly fix the component (for instance a die) into the transition piece, and then assemble both into the hole. In another embodiment, the transition piece can be produced directly around the die too. This may allow to exploit the component as a carrier for the transition piece. Taking such a measure may allow to further reduce or mitigate the risk of transition piece failure compared to assemble first the transition piece into the hole, and subsequently the die into the transition piece (which is however possible according to another exemplary embodiment of the invention).

Exemplary embodiments of the invention are applicable to all embedding and board-in-board concepts. Exemplary embodiments promote to obtain the goal of miniaturization and high integration.

Furthermore, depending of the component to be integrated, adding functionality to the component carrier beyond conducing electricity, is also enabled by exemplary embodiments of the invention. An exemplary embodiment may integrate a solid state battery as a component, which can be sustained by an energy harvester enabling autonomous energy systems. Another exemplary embodiment may use component carriers or boards having different properties (for example a high frequency compatible board and an ordinary board) and use transition pieces unifying such boards or component carriers.

One exemplary product obtained by carrying out an embodiment of the invention is a battery device, which may supply power directly from the component carrier. Furthermore, boards with different properties can be combined in a kind of PCB construction set or puzzle, fulfilling different requirements in terms of CTE, dielectric constant, loss factors, etc., in one unique platform.

Figure 1 to Figure 3 illustrate plan views of auxiliary structures 100 for embedding a component 102 in a component carrier 104.

Referring to **Figure 1****,** an auxiliary structure 100 is shown which comprises a rectangular solid state transition piece 106 for fully circumferentially enclosing a component 102 (compare Figure 4). According to Figure 1, the transition piece 106 is advantageously configured as a circumferentially closed annular frame. The solid-state transition piece 106 is made of a material becoming adhesive in a liquid state and being liquefiable by heat and/or pressure so as to fill a gap between the component 102 and surrounding component carrier material 108 (compare Figure 4) by applying heat and/or pressure. According to Figure 1, the transition piece 106 is configured as a single integral body. The solid-state transition piece 106 is made of an uncured or curable material. In the shown embodiment, the solid-state transition piece 106 is made of B-stage prepreg. By providing the solid-state transition piece 106 from prepreg or any other B-stage material, this material may re-melt during lamination so that resin (or the like) may flow for interconnecting the various elements and for closing gaps or voids and may therefore contribute to a stable intrinsic interconnection within the component carrier 104 under manufacture. Advantageously, the auxiliary structure 100 may be manufactured with low effort by molding at a molding temperature below the curing temperature of the material of the solid-state transition piece 106.

Referring to **Figure 2****,** the transition piece 106 shown there is composed of four strip shaped separate transition piece constituents which are here arranged to form a rectangle for substantially fully circumferentially enclosing a component 102. Only in the four edge portions, very small gaps remain at which a component 102 which is placed in an interior of the transition piece 106 is not completely enclosed by transition piece material. According to Figure 2, the strip shaped separate transition piece constituents have tapering end portions matched to one another. However, alternatively, the entire transition piece constituents may be provided with homogeneous width over their entire length. For instance, the material of the transition piece 106 may be a thermoplastic material or a hot melt adhesive.

Referring to **Figure 3****,** a transition piece 106 is shown which is formed by a granulate of solid particles arranged in a rectangular arrangement. According to Figure 3, the material of the transition piece 106 may be a grit and may be dispersed into a gap between a component 102 and component carrier material 108. For example, the material of the transition piece 106 according to Figure 3 may be a precursor of an adhesive foam. For instance, the material of the transition piece 106 may be a microcapsule-based two component system. Microcapsules may be filled with a precursor for a polyurethane (PU) foam or the like. If desired, the material of the transition piece 106 may further comprise a foaming agent. For instance by the application of mechanical pressure and/or heat, the microcapsules may break and the foaming reaction may be triggered. The consequence may be the generation of an adhesive foam gluing or adhering component carrier material 108 and electronic component 102 together. At the same time, the formed foam is properly compressible and is therefore capable of balancing out mechanical tensions (which may for instance occur due to different coefficients of thermal expansion between the material of the component 102 and the component carrier material 108.

**Figure 4** illustrates a plan view of a semifinished product 177 obtained during carrying out a batch procedure of manufacturing a plurality of component carriers 104 (compare Figure 11 to Figure 16, for example) according to an exemplary embodiment of the invention.

The illustrated semifinished product 177 comprises component carrier material 108 (for instance a PCB material, for example dielectric material such as FR4 or prepreg and/or electrically conductive material such as copper) with a plurality of recesses 110, and a plurality of auxiliary structures 100 (for instance as described referring to any of Figure 1 to Figure 3). The solid-state transition piece 106 of each of the auxiliary structures 100 is located within a corresponding one of the recesses 110 so as to define a respective accommodation volume for arranging a respective one of the plurality of electronic components 102 therein. As can be taken from Figure 4, each of the components 102 is accommodated in a respective one of the accommodation volumes. For instance, the components 102 may be semiconductor chips, batteries, or further component carriers (for manufacturing board-in-board devices). Since the adhesion between a respective electronic component 102 and the component carrier material 108 may be accomplished by material of the auxiliary structure 100 upon laminating the batch-type panel-size semifinished product 177 according to Figure 4 with at least one electrically conductive layer structure and/or with at least one electrically insulating layer structure (not shown in Figure 4), it is also possible that the component carrier material 108 is a fully cured core (for instance consisting of FR4 and copper).

In order to manufacture component carriers 104 based on the semifinished product 177, it is possible to temporarily liquefy the material of the transition pieces 106 by heat and/or pressure so as to fill the gaps between the components 102 and the surrounding component carrier material 108 and thereby adhere them together by the now adhesive transition piece material. As mentioned above, one or more further electrically insulating layer structures and/or one or more electrically conductive layer structures may be laminated on top and/or bottom of the semifinished product 177 shown in Figure 4. This lamination and the curing of the transition piece material may be advantageously carried out in a single common simultaneous procedure in which pressure and/or heat is applied.

In order to complete the formation of the component carriers 104, it is subsequently possible to singularize a so obtained structure into a plurality of separate component carriers 104, each comprising a portion of the component carrier material 108, one of the components 102 and one of the transition pieces 106 (however now in a fully cured state). Upon singularization, it is optionally possible to remove at least part of the material of the former auxiliary structure 100 from the manufactured component carrier 104.

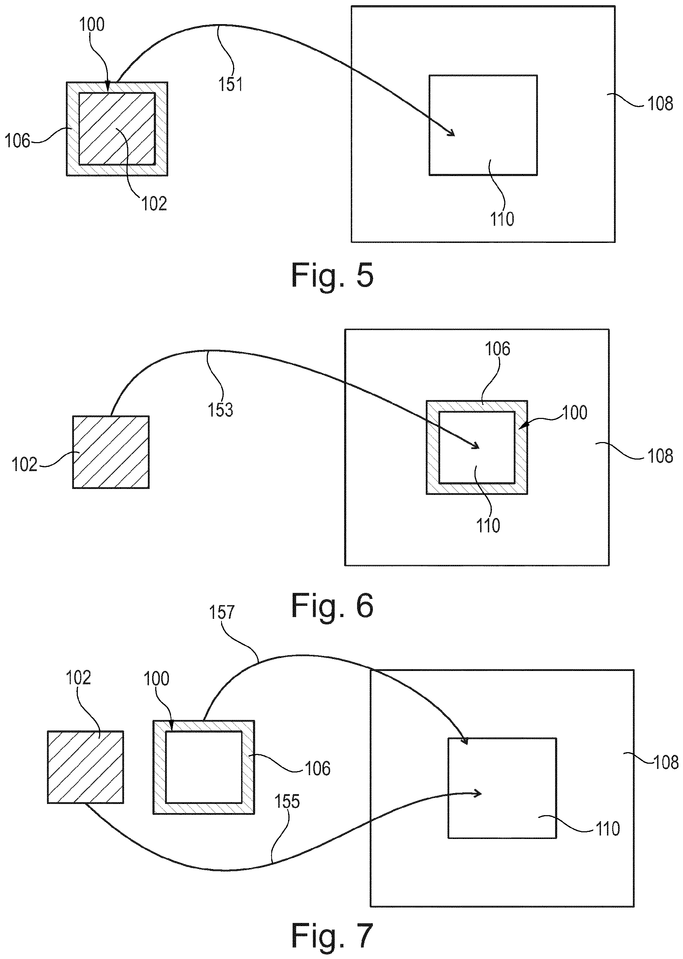

Figure 5 to Figure 7 illustrate plan views of showing three different procedures of embedding electronic components 102 in a recess 110 of component carrier material 108 using an auxiliary structure 100 according to exemplary embodiments of the invention.

Referring to **Figure 5****,** the component 102 is integrally formed with the surrounding transition piece 106, so that the integral component-transition piece-body may be placed (compare reference numeral 151) as a single piece into the recess 110 (for instance by a pick and place apparatus).

Referring to **Figure 6****,** the component carrier material 108 is integrally formed with and surrounds the transition piece 106 in the recess 110. According to Figure 6, the component 102 alone is placed (compare reference numeral 153) into the recess 110 which is already surrounded by the auxiliary structure 100.

Referring to **Figure 7****,** yet another mounting procedure is shown. As shown, the auxiliary structure 100, the component 102 and the component carrier material 108 are provided as three separate bodies. Consequently, it is possible to firstly place the auxiliary structure 100 into the recess 110 (compare reference numeral 157) and to subsequently insert the component 102 into the through hole of the transition piece-type auxiliary structure 100 (compare reference numeral 155), or vice versa.

Figure 8 to Figure 10 illustrate plan view of semifinished products 177 according to exemplary embodiments of the invention.

Referring to **Figure 8****,** only a single electronic component 102 is embedded within component carrier material 108 by means of an auxiliary structure 100 in between.

Referring to **Figure 9****,** two electronic components 102 are embedded within component carrier material 108 by means of two separate, spaced and unconnected auxiliary structures 100 according to another exemplary embodiment of the invention. According to Figure 9, one of the transition pieces 106 is configured as a frame fully circumferentially surrounding one of the components 102 in an interior of the component carrier material 108. The other one of the transition pieces 106 shown in Figure 9 is configured as an open structure with two free ends which only partially surrounds the other one of the components 102 in an edge portion (here a corner portion) of the component carrier material 108, which is considered as an illustrative example not being part of the invention.

Referring to **Figure 10****,** one auxiliary structure 100 and a further auxiliary structure 100 are located in a common recess 110 in the component carrier material 108 to thereby delimit two different accommodation volumes for two different electronic components 102. As shown, the auxiliary structure 100 and the further auxiliary structure 100 together substantially fully circumferentially surround the common recess 110. The auxiliary structures 100 moreover run through an interior of the recess 110 and hence divide the recess 110 into the two different accommodation volumes. Each of two electronic components 102 is placed in a respective one of the accommodation volumes or compartments defined by the auxiliary structures 100 in combination.

As an alternative to the configuration shown in Figure 10, it is also possible that the two auxiliary structures 100 are not inserted into a common recess 110 but are inserted into two separate recesses separated by a thin web of component carrier material 108 (for example similar as in Figure 9 but with the geometry according to Figure 10).

Figure 11 to Figure 16 illustrate cross-sectional views of component carriers 104 manufactured by methods of manufacturing component carriers 104 according to exemplary embodiments of the invention. Hence, Figure 11 to Figure 16 show schematic representations of end products resulting from framing a component 102 by an auxiliary structure 100 using different processes. In contrast to Figure 1 to Figure 10, the material of the auxiliary structure 100 has meanwhile been fully cured according to any of Figure 11 to Figure 16 under the influence of mechanical pressure and heat applied during the lamination with at least one electrically insulating layer structure 112 and at least one electrically conductive layer structure 114. The fact, that the material of the former auxiliary structure 100 is fully cured according to Figure 11 to Figure 16, is indicated by reference numeral 100'.

In **Figure 11, Figure 13** and **Figure 15****,** the component 102 is facing out (i.e. is exposed to an environment), while in **Figure 12, Figure 14** and **Figure 16** it is embedded in an interior the main PCB. Furthermore, in Figure 11 and Figure 12, the component 102 has the same height as the component carrier material 108 (particular a core). In Figure 13 and Figure 14, the component 102 is thinner than the component carrier material 108 (which also may be denoted as main PCB), whereas in Figure 15 and Figure 16, the component 102 is thicker than the component carrier material 108. In Figure 11, Figure 13 and Figure 15, the upper main surfaces of the component 100 and the component carrier material 108 are covered by an electrically insulating layer structure 112 and an electrically conductive layer structure 114, whereas only an electrically conductive layer structure 114 is provided at the bottom surface. In Figure 12, Figure 14 and Figure 16, the upper main surfaces of the component 100 and the component carrier material 108 are covered by an electrically insulating layer structure 112 and an electrically conductive layer structure 114, and an electrically conductive layer structure 114 and an electrically insulating layer structure 112 are provided at the bottom surfaces as well.

Substantially H-shaped plated through holes are shown as electrically conductive layer structures 114 on the right hand side of each of Figure 12, Figure 14 and Figure 16. Although corresponding plated through holes are not shown in Figure 11, Figure 13 and Figure 15, also these embodiments may be equipped with one or more of such substantially H-shaped plated through holes (not illustrated in these figures for the sake of simplicity).

Figure 17 to Figure 21 illustrate cross-sectional views of structures obtained during carrying out methods of manufacturing component carriers 104 according to exemplary embodiments of the invention.

In Figure 18 to Figure 21, three different embodiments of the manufacturing method are shown. The component 102 to be embedded or integrated may be as thick as the component carrier material 108 (see left hand side of any of Figure 18 to Figure 21), thinner than the component carrier material 108 (see middle of any of Figure 18 to Figure 21) or thicker than the component carrier material 108 (see right hand side of any of Figure 18 to Figure 21). For simplicity, the dielectric component carrier material 108 is only shown as a single layer. However, the dielectric component carrier material 108 can also be embodied as an N-layer PCB, where 2<N<20.

Referring to **Figure 17****,** processing starting from a pre-cut core (compare reference numeral 171) as component carrier material 108 fixed on a base 165 composed of a support 161 covered with a glue layer 163.

Referring to **Figure 18****,** one or more precut transition pieces, as auxiliary structure 100, is/are put into the recess 110, which is here a through hole. On the left hand side and on the right-hand side, three transition pieces are stacked. In the middle, two transition pieces are stacked. Hence, the number of transition pieces stacked in a recess 110 can be freely selected, in particular depending on the thickness of the component 102 to be embedded. Thereby, a board designer is enabled to configure the auxiliary structure 100 from one or more transition pieces 106 in an appropriate way.

Apart from its non-adhesive property in the solid state and its adhesive property in the liquid state, the material of the auxiliary structure 100 can be selected for improving or adjusting the properties of the component carrier 104 to be manufactured. For instance, a material of the auxiliary structure 100 may be selected so as to:
- reduce mechanical load in a transition region between the component carrier material 108 and the component 102; and/or
- reduce a thermal expansion mismatch between the component carrier material 108 and material of the component 102; and/or
- provide a thermal conductivity higher than the thermal conductivity of the component carrier material 108 and the component 102; and/or
- provide a high frequency compatibility better than a high frequency compatibility of the component carrier material 108 and the component 102.

Referring to **Figure 19****,** a respective electronic component 102 is inserted in the respective recess 110 in the component carrier material 108 in such a way that the component 102 is fully circumferentially surrounded by the solid auxiliary structure 100 having a non-adhesive property in the solid state and having a sticky or adhesive property in the liquid state. In other words, the component 102 is inserted into the central through hole of the transition pieces 106 so as to interpose the transition pieces 106 between the component carrier material 108 and the component 102.

Referring to **Figure 20****,** one or more electrically insulating layer structures 112 (for instance prepreg layers) and an electrically conductive layer structure 114 (for instance a copper foil) are attached to an upper main surface of the structures shown in Figure 19. In other words, electrically insulating material (which may be the same material as or another material than the material of the transition piece 106 and/or the core-type component carrier material 108) and electrically conductive material may be positioned on the whole PCB surface.

Referring to **Figure 21****,** the various layer structures shown in Figure 20 (including the at least one electrically conductive layer structure 114 and the at least one electrically insulating layer structure 112, as well as the auxiliary structure 100) are laminated together by the application of pressure, if desired supported by heat. During this lamination procedure, the material of the auxiliary structure 100 is temporarily liquefied by the pressure and/or heat applied in terms of the lamination. Thereby, gaps between the component 102 and the surrounding component carrier material 108 are filled with the now liquid, flowable and adhesive material of the transition pieces 106. The material of the auxiliary structure 100 is thereby cured and, after re-solidification, bridges the gap between the component 102 with regard to the component carrier material 108.

Figure 22 to Figure 25 illustrate further cross-sectional views of further structures obtained during carrying out the method described referring to Figure 17 to Figure 21. Hence, Figure 22 to Figure 25 show the continuation of the process described referring to Figure 17 to Figure 21. Two different routes can be pursued starting from the structure shown in Figure 21, leading to the component facing out (compare Figure 22 to Figure 25) or being integrated in the inner layers (compare Figure 26 to Figure 29). The processes hereby described are valid for all three cases (component thinner than, thicker than and as thick as the core).

Referring to **Figure 22****,** openings 169 are formed from the surface to the component 102 or contact pads in the inner layers.

Referring to **Figure 23****,** contacts are formed at the surface and in the inner layers up to the component 102.

Referring to **Figure 24****,** the outermost electrically conductive layer is structured or patterned on the surface.

Referring to **Figure 25****,** the support 165 may be optionally removed.

Figure 26 to Figure 29 illustrate alternative further cross-sectional views of further structures obtained during carrying out the method described referring to Figure 17 to Figure 21. In other words, the procedure described referring to Figure 26 to Figure 29 is an alternative to the procedure described referring to Figure 22 to Figure 25.

Referring to **Figure 26****,** the support 165 is optionally removed. An electrically insulating layer structure 112 and an electrically conductive layer structure 114 are laminated onto a lower main surface of the shown structure.

Referring to **Figure 27****,** openings 169 are formed to both opposing main surfaces to the component 102 or contact pads in the inner layers.

Referring to **Figure 28****,** contacts are formed at the surfaces and in the inner layers up to the component 102.

Referring to **Figure 29****,** the outermost electrically conductive layers are structured or patterned on the surface.

Plated through holes are shown as electrically conductive layer structures 114 on the right hand side of each of Figures 27 to 29. Although corresponding plated through holes are not shown in Figures 22 to 26, also these embodiments may be equipped with one or more of such plated through holes (not illustrated in these figures for the sake of simplicity).

Figure 30 to Figure 34 illustrate cross-sectional views of structures obtained during carrying out methods of manufacturing component carriers 104 according to other exemplary embodiments of the invention.

Referring to **Figure 30****,** processing starts from a pre-cut, uncoated dielectric layer as component carrier structure 108 fixed on an electrically conductive layer structure 114 (here embodied as a copper foil) by glue layer 163. Thereby, a recess 110 is formed as a blind hole.

In Figure 31 to Figure 34, three different embodiments of the manufacturing method are shown. The component 102 to be embedded or integrated may be as thick as the component carrier material 108 (see left hand side of any of Figure 31 to Figure 34), thinner than the component carrier material 108 (see middle of any of Figure 31 to Figure 34) or thicker than the component carrier material 108 (see right hand side of any of Figure 31 to Figure 34).

Referring to **Figure 31****,** one or more prefabricated transition pieces 106, as auxiliary structure 100, is/are put into the recess 110, which is here a blind hole (rather than a through hole). On the left hand side and on the right-hand side, three transition pieces 106 are stacked. In the middle, two transition pieces 106 are stacked. Hence, the number of transition pieces 106 stacked in a recess 110 can be selected depending on the thickness of the component 102 to be embedded, thereby configuring the auxiliary structure 100 in an appropriate way.

Referring to **Figure 32****,** a respective electronic component 102 is inserted in the respective recess 110 in the component carrier material 108 in such a way that the component 102 is fully circumferentially surrounded by the solid auxiliary structure 100. The respective electronic component 102 is adhered on its bottom surface on the glue layer 163.

Referring to **Figure 33****,** an electrically insulating layer structure 112 (for instance a prepreg layer) and an electrically conductive layer structure 114 (for instance a copper foil) are attached to an upper main surface of the structures shown in Figure 32.

Referring to **Figure 34****,** the various layer structures shown in Figure 33 are laminated together by the application of pressure, if desired supported by heat. During this lamination procedure, the material of the auxiliary structure 100 is temporarily liquefied by the pressure and/or heat applied in terms of the lamination. Thereby, gaps between the component 102 and the surrounding component carrier material 108 are filled with the now liquid and adhesive material of the transition pieces 106. The material of the auxiliary structure 100 is thereby cured and, after re-solidification, bridges the gap between the component 102 with regard to the component carrier material 108 (compare reference numeral 100').

Figure 35 to Figure 37 illustrate further cross-sectional views of further structures obtained during carrying out the method described referring to Figure 30 to Figure 34.

Thus, Figure 35 to Figure 37 show the continuation of the process described in Figure 30 to Figure 34. The processes hereby described are valid for all three cases (electronic component 102 thinner than, thicker than and as thick as the dielectric layer in form of the component carrier material 108).

Referring to **Figure 35****,** openings 169 are formed from both opposing main surfaces to the component 102 or contact pads in the inner layers.

Referring to **Figure 36****,** contacts are formed at the surfaces and in the inner layers up to the component 102.

Referring to **Figure 37****,** the outermost electrically conductive layers are structured or patterned on the surface.

**Figure 38** shows a three-dimensional view of a semifinished product 177 on batch level obtained during manufacturing component carrier 104 according to an exemplary embodiment of the invention. The component carrier material 108 is provided with pre-cut holes, see recesses 110. The dielectric transition pieces 106, as auxiliary structures 100, are inserted in these holes, as well as the components 102. Reference numerals 181 represents gaps which will be filled during lamination by the curing of the dielectric transition pieces 106.

**Figure 39** shows a plan view of a component carrier 104 in which an open ends-type transition piece 106 unifies component carrier material 108 and a component 102 to be connected thereto according to an illustrative example not forming part of the invention. According to Figure 39, the transition piece 106 is angled or is substantially L-shaped so as to form an interface between component carrier material 108 and component 102 at a rectangular recess in a corner region of the rectangular component carrier 104.

**Figure 40** shows a plan view of a component carrier 104 in which a freely shaped transition piece 106 is arranged between surrounding component carrier material 108 and a component 102 to be recessed or embedded in the component carrier material 108 according to another exemplary embodiment of the invention. Figure 40 illustrates that one or both of the component 102 and the transition piece 106 may have a free form or shape. In the shown embodiment, the frame type transition piece 106 has a wave shape which therefore increases the length of the transition piece 106 around component 102. This length increase also improves the mechanical robustness of the transition piece 106 and as a consequence of the component carrier 104.

**Figure 41** shows a plan view of a component carrier 104 in which a transition piece 106 is arranged between component carrier material 108 and multiple components 102 to be recessed or embedded in the component carrier material 108 according to another exemplary embodiment of the invention. Figure 41 therefore illustrates that multiple components 102 (in the shown embodiment four components 102) can be connected to component carrier material 108 by a transition piece 106 having a number of interior recesses shaped and dimensioned to correspond to the shape and dimensions of the components 102.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

## Claims

1. A semifinished product (177) obtainable during manufacturing a component carrier (104), wherein the semifinished product (177) comprises:
component carrier material (108) with a recess (110), wherein the recess (110) is a through-hole;
a base (165) on which the component carrier material (108) is fixed, wherein the base (165) comprises a support covered with a glue layer (163);
an auxiliary structure (100) comprising a transition piece (106) which is located within the recess (110) so as to define at least part of an accommodation volume;
wherein the transition piece (106) comprises or consists of a material which is solid, the material being liquefiable by heat and/or pressure so that
- when a component (102) is inserted in the recess (110), such that the component (102) is placed onto the base (165) and the transition piece (106) at least partially, in particular substantially fully circumferentially, encloses the component (102), and
- when heat and/or pressure is applied, the material liquefies to an adhesive state and flows thereby closing gaps or voids between the component (102) and the surrounding component carrier material.

2. The semifinished product (177) according to claim 1, wherein the semifinished product (177) comprises the component (102) in the accommodation volume.

3. The semifinished product (177) according to claim 1, wherein the transition piece (106) is formed by one of:
- a single annular structure;
- a plurality of separate strips; and
- a granulate.

4. The semifinished product (177) according to any of claims 1 to 3, further comprising a further auxiliary structure (100) having a further transition piece (106) located within the component carrier material (108) so as to define at least part of a further accommodation volume for arranging a further electronic component (102) therein.

5. The semifinished product (177) according to claim 4, comprising one of the following features:
wherein the auxiliary structure (100) and the further auxiliary structure (100) are located in separate recesses (110) in the component carrier material (108);
wherein the auxiliary structure (100) and the further auxiliary structure (100) are located in a common recess (110) in the component carrier material (108) to thereby delimit at least part of different accommodation volumes for different electronic components (102), wherein in particular the auxiliary structure (100) and the further auxiliary structure (100) together at least partially, in particular substantially fully circumferentially, surround the common recess (110), and at least one of the auxiliary structure (100) and the further auxiliary structure (100) divides the recess (110) into the different accommodation volumes.

6. The semifinished product (177) according to any of claims 1 to 5, comprising at least one of the following features:
wherein the component carrier material (108) comprises a core, in particular comprising fully cured dielectric material;
wherein at least part of at least one main surface of the component carrier material (108), the component (102) and/or material of the transition piece (106) is covered with at least one electrically insulating layer structure (112) and/or at least one electrically conductive layer structure (114).

7. The semifinished product (177) according to any of claims 1 to 6,
wherein the auxiliary structure (100) comprises one of the following features:
wherein the transition piece (106) is a single integral body;
wherein the transition piece (106) comprises a plurality of separate transition piece constituents, in particular strips, arrangeable for at least partly, in particular substantially fully circumferentially, enclosing a component (102).

8. The semifinished product (177) according to any of claims 1 to 7,
wherein the transition piece (106) comprises a curable material, in particular a cross-linkable material.

9. The semifinished product (177) according to any of claims 1 to 7,
wherein the phase transition piece (106) comprises at least one of:
- at least partially uncured resin, in particular B-stage resin, more particularly B-stage prepreg;
- a thermoplastic material;
- a hot melt adhesive; and
- a precursor of an adhesive foam.

10. The semifinished product (177) according to any of claims 1 to 7,
wherein the transition piece (106) has an irregular perimeter or a polygonal perimeter, in particular a rectangular perimeter, more particularly a square perimeter.

11. The semifinished product (177) according to any of claims 1 to 10,
wherein the auxiliary structure (100) comprises one of the following features:
wherein the transition piece (106) is a circumferentially closed frame;
wherein the transition piece (106) is an open structure which has free ends.

12. A method of manufacturing a component carrier (104), said component carrier comprising a base (165) on which the component carrier material (108) is fixed, said base comprising a support covered with a glue layer (163), wherein the method comprises:
arranging a component (102) in a recess (110) of a component carrier material (108) such that the component (102) is placed onto the base (165), wherein the recess is a through hole;
at least partially, in particular substantially fully circumferentially, surrounding the component (102) by a transition piece (106), said transition piece (106) comprising or consisting of a material which is solid;
transferring by heat and/or pressure the transition piece (106) into an adhesive state, by temporarily liquefying the transition piece (106), so as to at least partially adhesively fill a gap between the component (102) and the surrounding component carrier material (108).

13. The method according to claim 12, wherein the method comprises laminating at least one electrically conductive layer structure (114) and/or at least one electrically insulating layer structure (112) on the component (102) and the component carrier material (108).

14. The method according to any of claims 12 or 13,
wherein the method comprises:
arranging at least one further electronic component (102) in at least one further recess (110) of the component carrier material (108);
at least partially, in particular substantially fully circumferentially, surrounding the at least one further electronic component (102) by at least one further transition piece (106);
transferring by heat and/or pressure the at least one further transition piece (106) into an adhesive state, by temporarily liquefying the at least one further transition piece (106), so as to at least partially adhesively fill a gap between the at least one further electronic component (102) and the surrounding component carrier material (108), wherein the method in particular further comprises singularizing an obtained structure into a plurality of separate component carriers (104), each comprising a portion of the component carrier material (108), and at least one of the components (102) at least partially surrounded by at least one of the transition pieces (106).

15. The method according to any of claims 12 to 14, comprising at least one of the following features:
wherein the component carrier (104) is shaped as a plate;
wherein the component carrier (104) is configured as one of the group consisting of a printed circuit board, and a substrate;
configured as a laminate-type component carrier (104).

## Patentansprüche

1. Halbfertigprodukt (177), das während der Herstellung eines Komponententrägers (104) erhalten wird, wobei das Halbfertigprodukt (177) umfasst:
Komponententrägermaterial (108) mit einer Aussparung (110), wobei die Aussparung (110) ein Durchgangsloch ist;
eine Basis (165), auf der das Komponententrägermaterial (108) befestigt ist, wobei die Basis (165) einen mit einer Klebeschicht (163) bedeckten Träger umfasst;
eine Hilfsstruktur (100), umfassend ein Übergangsstück (106), das sich innerhalb der Aussparung (110) befindet, sodass es mindestens einen Teil eines Aufnahmevolumens definiert;
wobei das Übergangsstück (106) ein festes Material umfasst oder daraus besteht, wobei das Material durch Wärme und/oder Druck verflüssigbar ist, sodass
- wenn eine Komponente (102) in die Aussparung (110) eingesetzt wird, die Komponente (102) auf der Basis (165) platziert wird und das Übergangsstück (106) die Komponente (102) zumindest teilweise, insbesondere im Wesentlichen vollständig in Umfangsrichtung, umschließt, und
- wenn Wärme und/oder Druck aufgebracht wird, verflüssigt sich das Material in einen Haftzustand und fließt, wodurch Lücken oder Hohlräume zwischen der Komponente (102) und dem umgebenden Komponententrägermaterial geschlossen werden.

2. Halbfertigprodukt (177) nach Anspruch 1, wobei das Halbfertigprodukt (177) die Komponente (102) in dem Aufnahmevolumen umfasst.

3. Halbfertigprodukt (177) nach Anspruch 1, wobei das Übergangsstück (106) gebildet wird durch eines von:
- einer einzelnen ringförmigen Struktur;
- einer Vielzahl von separaten Streifen; und
- einem Granulat.

4. Halbfertigprodukt (177) nach einem der Ansprüche 1 bis 3, ferner umfassend eine weitere Hilfsstruktur (100) mit einem weiteren Übergangsstück (106), das innerhalb des Komponententrägermaterials (108) angeordnet ist, um zumindest teilweise ein weiteres Aufnahmevolumen zum Anordnen einer weiteren elektronischen Komponente (102) darin zu definieren.

5. Halbfertigprodukt (177) nach Anspruch 4, umfassend eines der folgenden Merkmale:
wobei die Hilfsstruktur (100) und die weitere Hilfsstruktur (100) in separaten Aussparungen (110) in dem Komponententrägermaterial (108) angeordnet sind;
wobei die Hilfsstruktur (100) und die weitere Hilfsstruktur (100) in einer gemeinsamen Aussparung (110) in dem Komponententrägermaterial (108) angeordnet sind, um dadurch zumindest teilweise unterschiedliche Aufnahmevolumina für unterschiedliche elektronische Komponenten (102) abzugrenzen, wobei insbesondere die Hilfsstruktur (100) und die weitere Hilfsstruktur (100) zusammen die gemeinsame Aussparung (110) zumindest teilweise, insbesondere im Wesentlichen vollständig umschließen, und mindestens eine der Hilfsstruktur (100) und der weiteren Hilfsstruktur (100) die Aussparung (110) in die unterschiedlichen Aufnahmevolumina unterteilt.

6. Halbfertigprodukt (177) nach einem der Ansprüche 1 bis 5, umfassend mindestens eines der folgenden Merkmale:
wobei das Komponententrägermaterial (108) einen Kern umfasst, der insbesondere ein vollständig ausgehärtetes dielektrisches Material umfasst;
wobei mindestens ein Teil mindestens einer Hauptoberfläche des Komponententrägermaterials (108), der Komponente (102) und/oder des Materials des Übergangsstücks (106) mit mindestens einer elektrisch isolierenden Schichtstruktur (112) und/oder mindestens einer elektrisch leitfähigen Schichtstruktur (114) bedeckt ist.

7. Halbfertigprodukt (177) nach einem der Ansprüche 1 bis 6,
wobei die Hilfsstruktur (100) eines der folgenden Merkmale umfasst:
wobei das Übergangsstück (106) ein einzelner integraler Körper ist;
wobei das Übergangsstück (106) eine Vielzahl von separaten Übergangsstückbestandteilen, insbesondere Streifen, umfasst, die so angeordnet werden können, dass sie eine Komponente (102) zumindest teilweise, insbesondere im Wesentlichen vollständig in Umfangsrichtung, umschließen.

8. Halbfertigprodukt (177) nach einem der Ansprüche 1 bis 7,
wobei das Übergangsstück (106) ein aushärtbares Material umfasst, insbesondere ein vernetzbares Material.

9. Halbfertigprodukt (177) nach einem der Ansprüche 1 bis 7,
wobei das Phasenübergangsstück (106) mindestens eines der Folgenden umfasst:
- mindestens teilweise ungehärtetes Harz, insbesondere B-Stage-Harz, insbesondere B-Stage-Prepreg;
- ein thermoplastisches Material;
- einen Schmelzklebstoff; und
- einen Vorläufer eines Klebeschaums.

10. Halbfertigprodukt (177) nach einem der Ansprüche 1 bis 7,
wobei das Übergangsstück (106) einen unregelmäßigen Umfang oder einen polygonalen Umfang, insbesondere einen rechteckigen Umfang, insbesondere einen quadratischen Umfang aufweist.

11. Halbfertigprodukt (177) nach einem der Ansprüche 1 bis 10,
wobei die Hilfsstruktur (100) eines der folgenden Merkmale umfasst:
wobei das Übergangsstück (106) ein in Umfangsrichtung geschlossener Rahmen ist;
wobei das Übergangsstück (106) eine offene Struktur ist, die freie Enden aufweist.

12. Verfahren zur Herstellung eines Komponententrägers (104), wobei der Komponententräger eine Basis (165) umfasst, auf der das Komponententrägermaterial (108) befestigt ist, wobei die Basis einen mit einer Klebeschicht (163) bedeckten Träger umfasst, wobei das Verfahren umfasst:
Anordnen einer Komponente (102) in einer Aussparung (110) eines Komponententrägermaterials (108), so, dass die Komponente (102) auf der Basis (165) platziert wird, wobei die Aussparung ein Durchgangsloch ist;
zumindest teilweise, insbesondere im Wesentlichen vollständig in Umfangsrichtung, Umgeben der Komponente (102) durch ein Übergangsstück (106), wobei das Übergangsstück (106) ein festes Material umfasst oder aus diesem besteht;
Überführen des Übergangsstücks (106) in einen Haftzustand durch Wärme und/oder Druck, indem das Übergangsstück (106) vorübergehend verflüssigt wird, sodass ein Spalt zwischen der Komponente (102) und dem umgebenden Komponententrägermaterial (108) zumindest teilweise adhäsiv gefüllt wird.

13. Verfahren nach Anspruch 12, wobei das Verfahren das Laminieren mindestens einer elektrisch leitfähigen Schichtstruktur (114) und/oder mindestens einer elektrisch isolierenden Schichtstruktur (112) auf die Komponente (102) und das Komponententrägermaterial (108) umfasst.

14. Verfahren nach einem der Ansprüche 12 oder 13,
wobei das Verfahren umfasst:
Anordnen mindestens einer weiteren elektronischen Komponente (102) in mindestens einer weiteren Aussparung (110) des Komponententrägermaterials (108);
zumindest teilweise, insbesondere im Wesentlichen vollständig in Umfangsrichtung, Umgeben der mindestens einen weiteren elektronischen Komponente (102) durch mindestens ein weiteres Übergangsstück (106);
Überführen des mindestens einen weiteren Übergangsstücks (106) durch Wärme und/oder Druck in einen Haftzustand, indem das mindestens eine weitere Übergangsstück (106) vorübergehend verflüssigt wird, sodass ein Spalt zwischen der mindestens einen weiteren elektronischen Komponente (102) und dem umgebenden Komponententrägermaterial (108) zumindest teilweise adhäsiv gefüllt wird, wobei das Verfahren insbesondere ferner das Zerlegen einer erhaltenen Struktur in eine Vielzahl von separaten Komponententrägern (104) umfasst, die jeweils einen Abschnitt des Komponententrägermaterials (108) umfassen, und wobei mindestens eine der Komponenten (102) zumindest teilweise von mindestens einem der Übergangsstücke (106) umgeben ist.

15. Verfahren nach einem der Ansprüche 12 bis 14, umfassend mindestens eines der folgenden Merkmale:
wobei der Komponententräger (104) als eine Platte geformt ist;
wobei der Komponententräger (104) als einer der Gruppe konfiguriert ist, bestehend aus einer Leiterplatte und einem Substrat;
konfiguriert als laminatartiger Komponententräger (104).

## Revendications

1. Produit semi-fini (177) pouvant être obtenu pendant la fabrication d'un porte-composants (104), dans lequel le produit semi-fini (177) comprend :
matériau de porte-composants (108) avec un évidement (110), dans lequel l'évidement (110) est un trou traversant ;
une base (165) sur laquelle le matériau de porte-composants (108) est fixé, dans lequel la base (165) comprend un support recouvert d'une couche de colle (163) ;
une structure auxiliaire (100) comprenant une pièce de transition (106) qui est située au sein de l'évidement (110) de manière à définir au moins une partie d'un volume de logement ;
dans lequel la pièce de transition (106) comprend ou est constituée d'un matériau qui est solide, le matériau étant liquéfiable par la chaleur et/ou la pression de sorte que
- lorsqu'un composant (102) est inséré dans l'évidement (110), de sorte que le composant (102) est placé sur la base (165) et la pièce de transition (106) enferme le composant (102) au moins partiellement, en particulier sensiblement de manière complètement circonférentielle, et
- lorsque de la chaleur et/ou une pression est appliquée, le matériau se liquéfie vers un état adhésif et s'écoule fermant ainsi des espaces ou des vides entre le composant (102) et le matériau de porte-composants environnant.

2. Produit semi-fini (177) selon la revendication 1, dans lequel le produit semi-fini (177) comprend le composant (102) dans le volume de logement.

3. Produit semi-fini (177) selon la revendication 1, dans lequel la pièce de transition (106) est formée par l'un parmi :
- une structure annulaire unique ;
- une pluralité de bandes séparées ; et
- un granulé.

4. Produit semi-fini (177) selon l'une quelconque des revendications 1 à 3, comprenant en outre une autre structure auxiliaire (100) ayant une autre pièce de transition (106) située au sein du matériau de porte-composants (108) de manière à définir au moins une partie d'un autre volume de logement pour y agencer un autre composant électronique (102).

5. Produit semi-fini (177) selon la revendication 4, comprenant l'une des caractéristiques suivantes :
dans lequel la structure auxiliaire (100) et l'autre structure auxiliaire (100) sont situées dans des évidements séparés (110) dans le matériau de porte-composants (108) ;
dans lequel la structure auxiliaire (100) et l'autre structure auxiliaire (100) sont situées dans un évidement commun (110) dans le matériau de porte-composants (108) pour délimiter ainsi au moins une partie de différents volumes de logement pour différents composants électroniques (102), dans lequel en particulier la structure auxiliaire (100) et l'autre structure auxiliaire (100) entourent ensemble l'évidement commun (110) au moins partiellement, en particulier sensiblement de manière complètement circonférentielle, et au moins l'une parmi la structure auxiliaire (100) et l'autre structure auxiliaire (100) divise l'évidement (110) en différents volumes de logement.

6. Produit semi-fini (177) selon l'une quelconque des revendications 1 à 5, comprenant au moins l'une des caractéristiques suivantes :
dans lequel le matériau de porte-composants (108) comprend un noyau, en particulier comprenant un matériau diélectrique entièrement durci ;
dans lequel au moins une partie d'au moins une surface principale du matériau de porte-composants (108), du composant (102) et/ou du matériau de la pièce de transition (106) est recouverte d'au moins une structure de couches électriquement isolantes (112) et/ou d'au moins une structure de couches électriquement conductrices (114).

7. Produit semi-fini (177) selon l'une quelconque des revendications 1 à 6,
dans lequel la structure auxiliaire (100) comprend l'une des caractéristiques suivantes :
dans lequel la pièce de transition (106) est un corps monobloc unique ;
dans lequel la pièce de transition (106) comprend une pluralité de constituants de pièce de transition séparés, en particulier des bandes, pouvant être agencés pour enfermer un composant (102) au moins partiellement, en particulier sensiblement de manière complètement circonférentielle.

8. Produit semi-fini (177) selon l'une quelconque des revendications 1 à 7,
dans lequel la pièce de transition (106) comprend un matériau durcissable, en particulier un matériau réticulable.

9. Produit semi-fini (177) selon l'une quelconque des revendications 1 à 7,
dans lequel la pièce de transition de phase (106) comprend au moins l'un parmi :
- résine au moins partiellement non durcie, en particulier résine de stade B, plus particulièrement préimprégné de stade B ;
- un matériau thermoplastique ;
- un adhésif thermofusible ; et
- un précurseur d'une mousse adhésive.

10. Produit semi-fini (177) selon l'une quelconque des revendications 1 à 7,
dans lequel la pièce de transition (106) a un périmètre irrégulier ou un périmètre polygonal, en particulier un périmètre rectangulaire, plus particulièrement un périmètre carré.

11. Produit semi-fini (177) selon l'une quelconque des revendications 1 à 10,
dans lequel la structure auxiliaire (100) comprend l'une des caractéristiques suivantes :
dans lequel la pièce de transition (106) est un cadre fermé de manière circonférentielle ;
dans lequel la pièce de transition (106) est une structure ouverte qui possède des extrémités libres.

12. Procédé de fabrication d'un porte-composants (104), ledit porte-composants comprenant une base (165) sur laquelle le matériau de porte-composants (108) est fixé, ladite base comprenant un support recouvert d'une couche de colle (163), dans lequel le procédé comprend :
l'agencement d'un composant (102) dans un évidement (110) d'un matériau de porte-composants (108) de telle sorte que le composant (102) est placé sur la base (165), dans lequel l'évidement est un trou traversant ;
le fait d'entourer le composant (102) au moins partiellement, en particulier sensiblement de manière complètement circonférentielle, par une pièce de transition (106), ladite pièce de transition (106) comprenant ou étant constituée d'un matériau qui est solide ;
le transfert par chaleur et/ou pression de la pièce de transition (106) dans un état adhésif, en liquéfiant temporairement la pièce de transition (106), de manière à remplir au moins partiellement de manière adhésive un espace entre le composant (102) et le matériau de porte-composants environnant (108) .

13. Procédé selon la revendication 12, dans lequel le procédé comprend la stratification d'au moins une structure de couches électriquement conductrices (114) et/ou d'au moins une structure de couches électriquement isolantes (112) sur le composant (102) et le matériau de porte-composants (108).

14. Procédé selon l'une quelconque des revendications 12 ou 13,
dans lequel le procédé comprend :
l'agencement d'au moins un autre composant électronique (102) dans au moins un autre évidement (110) du matériau de porte-composants (108) ;
le fait d'entourer l'au moins un autre composant électronique (102) au moins partiellement, en particulier sensiblement de manière complètement circonférentielle, par au moins une autre pièce de transition (106) ;
le transfert par chaleur et/ou pression de l'au moins une autre pièce de transition (106) dans un état adhésif, en liquéfiant temporairement l'au moins une pièce de transition supplémentaire (106), de manière à remplir au moins partiellement de manière adhésive un espace entre l'au moins un autre composant électronique (102) et le matériau de porte-composants environnant (108), dans lequel le procédé comprend en outre en particulier la singularisation d'une structure obtenue en une pluralité de porte-composants séparés (104), comprenant chacun une portion du matériau de porte-composants (108), et au moins un des composants (102) étant au moins partiellement entouré par au moins une des pièces de transition (106).

15. Procédé selon l'une quelconque des revendications 12 à 14, comprenant au moins l'une des caractéristiques suivantes :
dans lequel le porte-composants (104) est formé comme une plaque ;
dans lequel le porte-composants (104) est configuré comme l'un parmi le groupe constitué d'une carte de circuit imprimé et d'un substrat ;
configuré comme un porte-composants de type stratifié (104).
